(19) Europäisches Patentamt
European Patent Office
Office européen des brevets

(11) **EP 0 557 318 B1**

(12) **EUROPÄISCHE PATENTSCHRIFT**

(45) Veröffentlichungstag und Bekanntmachung des Hinweises auf die Patenterteilung:
**05.03.1997 Patentblatt 1997/10**

(51) Int Cl.$^6$: **H01L 21/18**, H01L 25/07, H01L 21/98

(21) Anmeldenummer: **91918830.0**

(22) Anmeldetag: **07.11.1991**

(86) Internationale Anmeldenummer:
**PCT/DE91/00863**

(87) Internationale Veröffentlichungsnummer:
**WO 92/09099 (29.05.1992 Gazette 1992/12)**

(54) **VERFAHREN ZUR HERSTELLUNG VON HALBLEITERELEMENTEN, INSBESONDERE VON DIODEN**

METHOD OF MANUFACTURING SEMICONDUCTOR ELEMENTS, IN PARTICULAR DIODES

PROCEDE POUR LA FABRICATION D'ELEMENTS SEMICONDUCTEURS, EN PARTICULIER DE DIODES

(84) Benannte Vertragsstaaten:
**DE FR GB IT**

(30) Priorität: **14.11.1990 DE 4036222**

(43) Veröffentlichungstag der Anmeldung:
**01.09.1993 Patentblatt 1993/35**

(73) Patentinhaber: **ROBERT BOSCH GMBH**
**70442 Stuttgart (DE)**

(72) Erfinder:
• **SPITZ, Richard**
**D-7410 Reutlingen 17 (DE)**

• **GOEBEL, Herbert**
**D-7410 Reutlingen 17 (DE)**
• **WILLMANN, Martin**
**D-7410 Reutlingen (DE)**
• **DENNER, Volkmar**
**D-7417 Pfullingen (DE)**
• **BIALLAS, Vesna**
**D-7410 Reutlingen (DE)**
• **BARTH, Stephan-Manuel**
**D-82194 Gröbenzell (DE)**

(56) Entgegenhaltungen:
**EP-A- 0 190 935          EP-A- 0 269 294**
**EP-A- 0 366 208          WO-A-88/00395**
**DE-A- 2 339 006          FR-A- 2 192 380**

**Beschreibung**

**Stand der Technik**

Die Erfindung betrifft ein Verfahren zur Herstellung von Halbleiterelementen, insbesondere von Dioden, bei dem mindestens zwei Halbleiterkörper miteinander verbunden werden.

Es sind Verfahren zur Herstellung von Halbleiterelementen bekannt, mit denen sich beispielsweise Dioden unterschiedlicher Struktur und Charakteristik erstellen lassen. So sind z.B. in "High Current Characteristics Of Asymmetrical p-i-n Diodes Having Low Forward Voltage Drops" M. Naito, H. Matsuzaki, T. ogawa, IEEE Transactions On Electron Devices, Vol. ED-23, No. 8,1976, S. 945 ff. und in EP 0 122 598 A2 asymmetrische Dioden beschrieben, die auf einer ihrer beiden Waferseiten niedrige Oberflächenkonzentration besitzen.

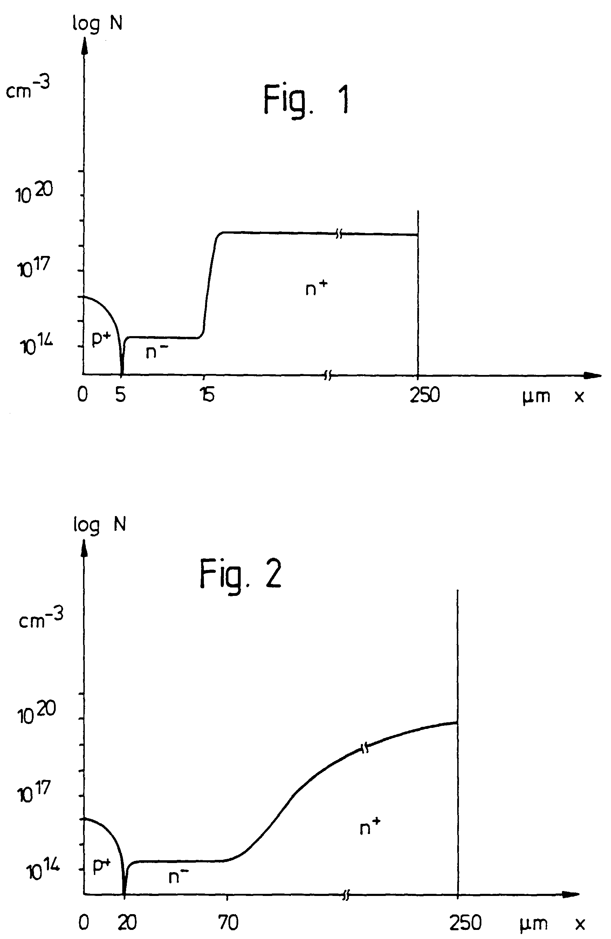

Das Dotierungskonzentrationsprofil der aus diesen Druckschriften bekannten asymmetrischen Dioden ist in Figur 1 veranschaulicht. Auf der Abszisse ist (in µm) die jeweilige lagemäßige Position eines Querschnitts durch die asymmetrische Diode aufgetragen, während auf der Ordinate die zu der jeweiligen Querschnittsposition gehörende Störstoffkonzentration in logarithmischem Maßstab (in $cm^{-3}$) angegeben ist. Die Gesamtlänge der asymmetrischen Diode beträgt 250 µm.

Zur Herstellung der in Figur im Querschnitt gezeigten Diode wird auf ein $n^+$-Substrat von 235 µm Dicke eine dünne $n^-$-schicht epitaktisch abgeschieden, und zwar mit einer Dicke von 15 µm. In die aufgebrachte epitaktische Schicht wird von der Oberseite Bor mit niedriger Oberflächenkonzentration eingebracht, so daß eine ca. 5 µm starke $p^+$-Schicht gebildet wird. Bei diesem Verfahren sind die für die Herstellung der Epitaxieschicht erforderlichen hohen Kosten und der benötigte Verfahrensaufwand nachteilig. Dies beruht insbesondere darauf, daß die Rückseite des hoch dotierten $n^+$-Substrats während der Abscheidung mit Oxiden oder anderen Schichten versiegelt werden muß, um Autodoping zu vermeiden.

In der EP 0 350 816 A2 ist ein abgeändertes Herstellungsverfahren zur Ausbildung asymmetrischer Dioden offenbart. Der sich bei diesem Verfahren ergebende Dotierungskonzentrationsverlauf ist in Figur 2 veranschaulicht. In gleicher Weise wie bei Figur 1 ist auch bei Figur 2 auf der Abszisse der Verlauf eines Querschnitts durch die asymmetrische Diode (in µm) angegeben, während auf der Ordinate die bei einer jeweiligen Position vorhandene Dotierungskonzentration in logarithmischem Maßstab (in $cm^{-3}$) aufgetragen ist. Bei dem aus der EP 0 350 816 A2 bekannten Verfahren wird in ein schwach mit Phosphor dotiertes $n^-$-substrat tief Phosphor eindiffundiert. Üblicherweise erfolgt dies dergestalt, daß in ein dickes Substrat beidseitig Phosphor eingebracht wird, um eine andernfalls notwendige Vorderseitenabdeckung zu vermeiden, die zudem bei den sehr langen Diffusionszeiten von mehr als einer Woche undicht werden würde. Anschließend wird die eine Oberseite des Substrats mechanisch abgetragen, so daß die eine Diffusionsschicht, z.B. die Vorderseitendiffusionsschicht, entfernt wird, während die andere Diffusionsschicht erhalten bleibt. Die mechanische Abtragung erfolgt in einem solchen Ausmaß, daß die gewünschte Mittelzonenbreite der $n^-$-Schicht zuzüglich einer für eine nachfolgende Diffusion erforderlichen Schichtdicke erhalten wird. Bei der nachfolgenden Diffusion wird in die $n^-$-Schicht flach Bor mit niedriger Oberflächenkonzentration eindiffundiert, so daß schließlich der in Figur 2 veranschaulichte Dotierungsverlauf erhalten wird. Bei diesem Verfahren ist die außerordentlich lange Phosphordiffusionszeit von Nachteil.

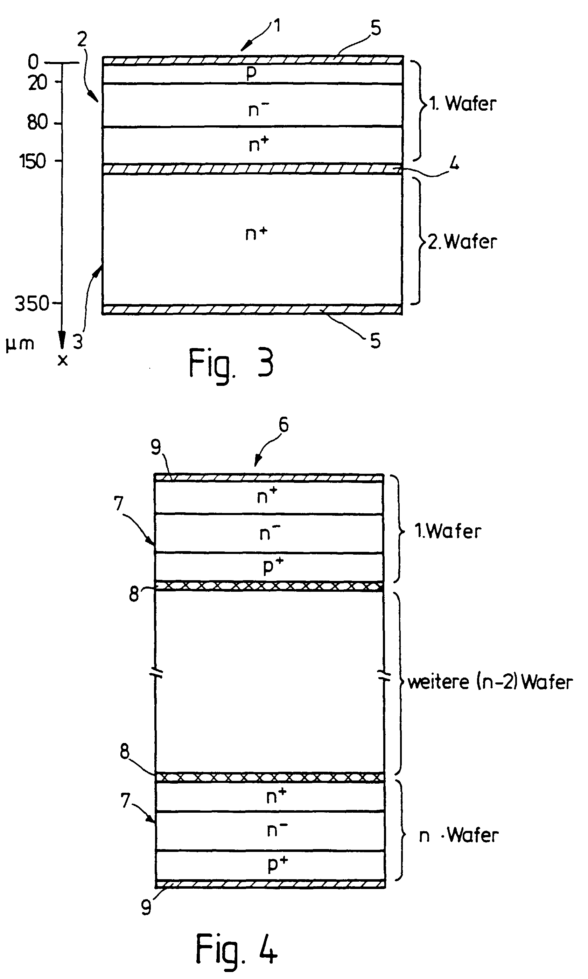

Ein weiteres Herstellungsverfahren ist aus der DE 38 23 348 A1 bekannt. Mit diesem Verfahren lassen sich asymmetrische Dioden herstellen, wie sie beispielsweise in Figur 3 gezeigt sind.

In Figur 3 ist eine asymmetrische Diode 1 gezeigt, die aus zwei aufeinandergesetzten Wafern 2 und 3 besteht, die über eine Löt- oder Legierungsschicht 4 miteinander verbunden sind. Auf der Oberund der Unterseite der asymmetrischen Diode 1 ist jeweils eine Metallschicht 5 aufgebracht. Im einzelnen wird die in Figur 3 gezeigte asymmetrische Diode dadurch hergestellt, daß in ein dünnes $n^-$-Substrat zunächst von einer Seite Phosphor eindiffundiert wird, um eine $n^+$-Schicht zu erzeugen. In einem nachfolgenden Diffusionsschritt wird dann von der anderen Seite Bor flach mit niedriger Oberflächenkonzentration eingetrieben, so daß der in Figur 3 gezeigte Dotierungsverlauf des Wafers 2 entsteht. Wie aus der in Figur 3 links dargestellten Bemaßungsskala hervorgeht, beträgt die Waferdicke lediglich ca. 150 µm, so daß der Wafer sehr bruchanfällig ist. Aus diesem Grund wird auf der Seite der $n^+$-Schicht des Wafers 2 der Wafer 3 angebracht, der zur Unterstützung des Wafers 2 dient, eine Dicke von 200 µm besitzt und $n^+$-dotiert ist. Die Verbindung der beiden Wafer 2, 3 erfolgt über die Löt- oder Legierungsschicht 4. Dieses Verfahren hat die Nachteile, daß die Herstellungskosten hoch sind, und daß die Löt- oder Legierungsschicht 4 nicht optimal der Wärmeausdehnung des Siliciums angepaßt ist, so daß thermische Spannungen mit Gefahr der Beeinträchtigung der Funktionsfähigkeit und unerwünschter Charakteristikveränderungen besteht. Ferner ist das Zerteilen des Verbund-Wafers in einzelne Chips problematisch.

Ferner ist es bekannt, zur Bildung von Hochspannungsdioden mehrere Wafer übereinander zu stapeln. In Figur 4 ist eine übliche Ausführungsform einer gestapelten Hochspannungsdiode 6 gezeigt, bei der mehrere identische Wafer 7 unter jeweiliger Zwischenlage von Löt- oder Legierungsschichten 8 übereinandergestapelt sind. Auf der Oberund Unterseite des Waferverbunds sind Metallschichten 9 für die elektrische Kontaktierung aufgebracht.

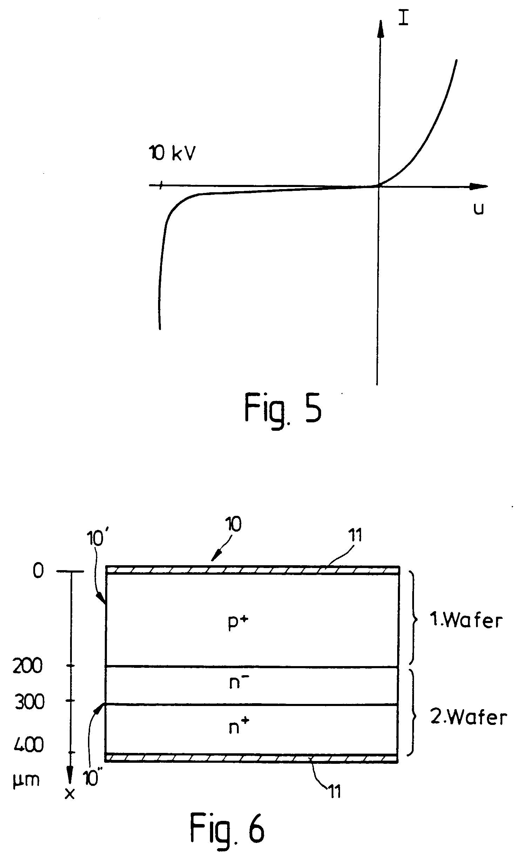

Die Herstellung der in Figur 4 gezeigten Hochspannungsdiode 6 erfolgt dergestalt, daß zunächst - zur Herstellung eines Wafers 7 - in ein schwach mit Phosphor dotiertes Substrat von der einen Seite Phosphor und dann von der anderen Seite Bor eindiffundiert wird. Nach dem Entfernen der Diffusionsgläser werden auf beiden Waferseiten Metallschichten abgeschieden. Danach werden die einzelnen Wafer 7 aufeinander gestapelt und durch Löten oder Legieren miteinander verbunden. Die Spannungs-Strom-Kennlinie der bekannten Hochspannungsdiode 6 ist in Figur 5 aufgetragen und besitzt die übliche Diodencharakteristik.

Die Nachteile dieses Verfahrens sind darin zu sehen, daß es hohen Aufwand erfordert, daß die Löt- und Legierungsschritte schwer beherrschbar sind und daß die Metallschichten beim Sägen und Ätzen stören.

Ferner ist es allgemein bekannt, Siliciumwafer nach dem Silicium-Verschmelzungs-Verbindungsverfahren (SFB = Silicon Fusion Bonding) unlösbar miteinander zu verbinden. Bei diesem Verbindungsverfahren werden folgende Prozeßschritte durchgeführt: Zunächst werden die einzelnen Wafer nach dem sogenannten RCA-Verfahren gereinigt und dann die polierten Flächen der zu verbindenden Wafer in staubfreier Atmosphäre aufeinandergelegt. Die Wafer haften zunächst durch Adhäsion aneinander. Nachfolgend werden die miteinander verbundenen Wafer einer Temperaturbehandlung über 1000° für eine Behandlungszeit von mindestens einer Stunde ausgesetzt. Vorzugsweise wird der Waferverbund zwei Stunden lang unter Stickstoffatmosphäre bei 1080° C gehalten. Bei dieser Behandlung entsteht eine unlösbare Verbindung, die sich durch besonders günstige elektrische Eigenschaften auszeichnet.

Aus der EP-0 269 294 A1 und der EP-0 190 935 A3 sind bereits Verfahren zur Herstellung von Halbleiterelementen bekannt, bei denen zwei Siliziumwafer miteinander verbunden werden. Die Verbindung erfolgt durch Verschmelzung. Einer der Siliziumwafer weist zwei Schichten eines ersten Leitungstyps und der zweite Wafer mindestens eine Schicht eines anderen Leitungstyps auf. Aus der FR-A-2 192 380 ist es bekannt zur Herstellung von Hochspannungsdioden mehrere Halbleiterkörper in Stapelbauweise aufeinander anzuordnen und miteinander zu verbinden. Aus der EP-0 190 508 A2 ist ein Verfahren bekannt, bei dem zwei Halbleiterwafer mit unterschiedlicher Gitterkonstante miteinander verbunden werden. Aus der WO-A-8 800 395 sind stapelförmige Diodenanordnungen bekannt, bei denen eine Vielzahl von n- und p-dotierten Siliziumplatten miteinander verbunden werden.

**Vorteile der Erfindung**

Das erfindungsgemäße Verfahren mit den im Hauptanspruch genannten Merkmalen hat demgegenüber den Vorteil, daß Halbleiterelemente hergestellt werden, deren Ladungsträgerlebensdauer am pn Übergang auf einfache Weise gezielt gesteuern wird. Weiterhin lassen sich die Halbleiterelemente mit geringen Kosten und kurzen Herstellzeiten herstellen. Damit sind die erfindungsgemäß hergestellten Halbleiterelemente sehr gut als Dioden geeigenet. Selbstverständlich können durch Einbau zusätzlicher pn-Übergänge auch andere Halbleiterelemente wie etwa Transistoren und andere Bauelemente hergestellt werden.

Die erfindungsgemäß hergestellten Halbleiterelemente zeichnen sich ferner durch geringe Parameterstreuung und sehr gut elektrische Eigenschaften aus. Weiternhin sind in der Regel keine besonderen Abdeckmaßnahmen erforderlich. Durch die erfindungsgemäßen Maßnahmen lassen sich darüber hinaus Strukturen schaffen, bei denen an der Verbindungsfläche höher und schwächer dotierte Schichten desselben Leitungstyps aneinnander grenzen, so daß $n^+/n$-oder $p^+/p$-Strukturen geschaffen werden, ohne daß eine tiefe Rückseitendiffusion oder die Aufbringung von Epitaxieschichten auf (geringer oder höher dotierten) Substraten notwendig ist.

Bei Verwendung geeignet behandelter Wafer lassen sich erfindungsgemäß in sehr einfacher Weise pin-Diodenstrukturen bzw. $p^+nn^+$-Dioden schaffen, wobei der pn-Übergang nach dem SFB-Verfahren hergestellt wird. Weiterhin lassen sich mit der Erfindung Leistungsdioden herstellen, die sehr schnelles und weiches Abschaltverhalten bei niedriger Flußspannung besitzen. Insbesondere wenn der eine Halbleiterkörper homogen und hoch dotiert (z.B. mit Bor) ist, ist die Flußspannung auch bei hohen Strömen sehr gering. Weiterhin lassen sich Halbleiterelemente erzielen, die äußerst geringen spezifischen Widerstand von 1 mOhm.cm besitzen, während der Durchschnittswert des spezifischen Widerstands bei herkömmlichen Halbleiterelementen bestenfalls bei 50 mOhm.cm liegt.

Ferner lassen sich mit der Erfindung Hochspannungsdioden in gestapelter Ausführungsform erzeugen, ohne daß zwischen den einzelnen, aufeinander gestapelten Wafern irgendwelche Zwischenschichten in Form von Löt- oder Legierungsschichten benötigt werden. Damit entfallen diese in der Regel schwer beherrschbaren Löt- oder Legierungsschritte für die Waferverbindung.

Der Entfall von Metallschichten zwischen den miteinander zu verbindenden Wafern hat ferner ganz allgemein die Vorteile, daß keine Wärmeausdehnungsprobleme aufgrund unterschiedlicher Wärmeausdehnungsfaktoren an der Verbindungsfläche zwischen den Wafern vorhanden sind. Gleichfalls entfallen Ätzprobleme. Darüber hinaus ist das Zerteilen der Waferstrukturen in einzelne Chips einfach, da keine störenden Metallschichten dazwischen liegen.

Des weiteren lassen sich mit der Erfindung in einfacher Weise sogenannte "hängende Injektionsprofile" erzeugen, durch die eine schnelle und weiche umschaltung der Diode erzielt wird. Die "hängenden Injektionsprofile" begünstigen die Ausräumung der mit Ladungsträgern überschwemmten $n^-$-Mittelzone bei Umschaltung der Diode aus der Flußrichtung - unter Belastung mit hohen Strömen - in den Sperrzustand. Bislang wurden "hängende Injektionsprofile" nur

EP 0 557 318 B1

durch kostenaufwendige Bestrahlung mit Protonen definierter Eindringtiefe erreicht, wie dies in der DE 31 17 202 C2 und dem Aufsatz "Schnelle Dioden" von H. Schlangenotto, M. Füllmann, W.-D. Nowak, AEG-Forschungsinstitut, Frankfurt/Main, näher beschrieben ist.

Darüber hinaus läßt sich gezielt die Ladungsträgerlebensdauer am pn-Übergang steuern, und zwar durch Verwendung von Halbleiterkörpern unterschiedlicher Gitterkonstanten. Ferner läßt sich die Ladungsträgerlebensdauer am pn-Übergang noch deutlich weiter reduzieren, und zwar insbesondere duch Einbau von Fremdatomen in die Kontaktzone zwischen den miteinander verbundenen Wafern. Aufgrund der niedrigen Temperaturen und kurzen Behandlungzeiten beim Verbinden der Halbleiterkörper sind die Rekombinationszentren in der Nähe des pn-Übergangs angereichert, was zur Verbesserung des Ausmaßes des "hängenden Injektionsprofils" beiträgt.

Die erfindungsgemäßen Maßnahmen wirken sich insbesondere bei der Fertigung hochsperrender Bauelemente besonders günstig aus, die erfindungsgemäß trotz hoher Sperrfähigkeit dennoch niedrige Flußspannung besitzen und schnell- und weichschaltend sind.

Darüber hinaus lassen sich die Betriebsparameter der Halbleiterelemente durch mechanisches oder chemisches Abtragen der höher oder niedriger dotierten Schichten bei Bondung von Wafern aus Halbleitermaterial desselben Leitungstyps gezielt einstellen. Die zur Ausbildung eines pn-Übergangs erforderliche Schicht des entgegengesetzten Leitungstyps kann nach dem Verbindungsschritt stattfinden, wird vorzugsweise jedoch gleichzeitig mit dem Verbindungsschritt durchgeführt, da aufgrund der simultanen Ausführung der Diffusion auf der Vorderseite und dem SFB-Verbindungsschritt auf der Rückseite eines Wafers eine fertige Halbleiterstruktur in äußerst kurzer Zeit hergestellt werden kann. Statt einer Diffusion in eine der freiliegenden Hauptflächen der miteinander zu verbindenden Wafer kann die Diffusion auch durch Einbringen von Fremdatomen in die Kontaktzone zwischen den Wafern stattfinden, was den Vorteil hat, daß die Diffusionsschicht sich einerseits halbleiterelementintern ausbildet und andererseits die Umgebungsatmosphäre von Dotiermaterial freigehalten werden kann, so daß keine unerwünschte Dotierung auch anderer Halbleiterelementbereiche resultieren kann. Zugleich können Abdeckmaßnahmen entfallen.

Die Beschichtung der Halbleiterelementoberflächen mit Metall vor Zerteilung des Wafers in einzelne Chips bringt darüber hinaus den Vorteil, daß bei dem nachfolgenden Ätzschritt zur Beseitigung von Störungen an den Seitenflächen keine besondere Abdeckbehandlung der Chip-Oberflächen erforderlich ist.

**Zeichnung**

Die Erfinung wird im folgenden anhand der Figuren näher erläutert. Es zeigen:

Figur 1    den Verlauf der Dotierungskonzentration einer bekannten asymmetrischen Diode,

Figur 2    den Verlauf der Dotierungskonzentration einer nach einem anderen Herstellungsverfahren hergestellten asymmetrischen Diode,

Figur 3    einen Querschnitt durch eine nach einem bekannten Herstellungsverfahren hergestellten Diode mit zwei miteinander verbundenen Wafern,

Figur 4    einen Querschnitt durch eine bekannte Ausführungsform einer gestapelten Hochspannungsdiode,

Figur 5    den Kennlinienverlauf der Hochspannungsdiode gemäß Figur 4,

Figur 6    einen Querschnitt durch ein erstes Ausführungsbeipiel einer nach dem erfindungsgemäßen Verfahren hergestellten Leistungsdiode,

Figur 7    den Verlauf der Dotierungskonzentration der Leistungsdiode gemäß Figur 6,

Figur 8    das Dotierungsprofil für eine nach einem bekannten Verfahren hergestellte Diode und eine nach dem erfindungsgemäßen Verfahren gefertigte Diode,

Figur 9    Injektionsprofile, die sich bei der herkömmlichen und der erfindungsgemäßen Ausgestaltung einstellen,

Figur 10    einen Querschnitt durch ein nach dem erfindungsgemäßen Verfahren hergestelltes Halbleiterelement,

Figur 11    eine Darstellung experimenteller Werte für die Ladungsträgerlebensdauer abhängig von unterschiedlichen kristallographischen Orientierungswinkeln zwischen den miteinander verbundenen Halbleiterkörpern,

4

Figur 12 Kennlinien für ein nach dem erfindungsgemäßen Verfahren hergestelltes Halbleiterelement in Gegenüberstellung mit einem bekannten Halbleiterelement,

Figur 13 den Verlauf der Dotierungskonzentration bei einem nach dem erfindungsgemäßen Verfahren hergestellten Halbleiterelement in Form einer asymmetrischen Diode,

Figur 14 den Dotierungskonzentrationsverlauf bei einer nach einem abgeänderten, im Rahmen der Erfindung liegenden Verfahren hergestellten asymmetrischen Diode,

Figur 15 einen Querschnitt durch eine gestapelte Hochspannungsdiode, die gemäß einer Variante des erfindungsgemäßen Verfahrens hergestellt wurde, und

Figur 16 den Kennlinienverlauf der Hochspannungsdiode gemäß Figur 15.

## Beschreibung der Ausführungsbeispiele

In Figur 6 ist in Form eines Querschnitts der Schichtaufbau eines nach dem erfindungsgemäßen Verfahren hergestellten Halbleiterelements in Form einer Leistungsdiode 10 dargestellt. Die Leistungsdiode besitzt beidseitig hohe Oberflächenkonzentration und weist schnelles und weiches Abschaltverhalten bei niedriger Flußspannung auf. Die Leistungsdiode 10 besteht aus zwei Halbleiterkörpern 10', 10'', die nach dem Silicium-Verschmelzungs-Verbindungsverfahren (SFB-Verfahren) miteinander verbunden sind. Vorzugsweise wird das SFB-Verfahren bei diesem wie auch bei den weiteren Ausführungsformen bei Temperaturen über 1000° C für mehr als eine Stunde, insbesondere bei 1080° C für zwei Stunden unter Stickstoffatmosphäre, durchgeführt.

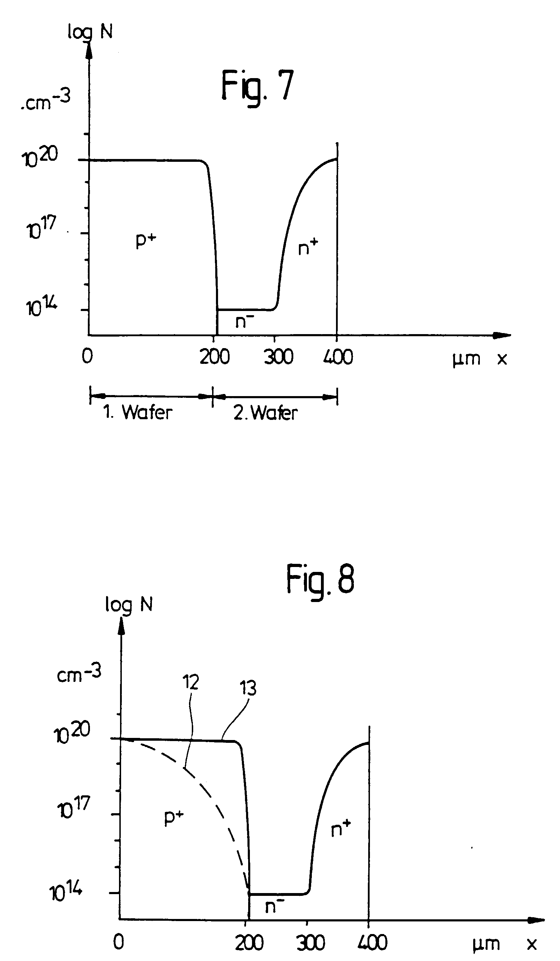

Der Halbleiterkörper 10' besitzt homogene, hohe $p^+$-Dotierung (insbesondere Bor) und weist eine Dicke von 200 µm auf. Der zweite Halbleiterkörper 10'' besitzt gleichfalls eine Dicke von 200 µm und besteht aus zwei Schichten des n-Leitungstyps, die jedoch unterschiedliche Dotierungskonzentration haben. Aus Figur 7 ist der Verlauf der Dotierungskonzentration der beiden Halbleiterkörper 10', 10'' ersichtlich.

Zur Herstellung des Halbleiterelements gemäß Figur 1 wird zunächst der Halbleiterkörper 10'' in bekannter Weise von der Rückseite her mit Phosphor dotiert. Nach der Diffusion verbleibt vom ursprünglichen Halbleiterkörper 10'' eine Zone von ca. 100 µm Dicke undiffundiert zurück, so daß der Halbleiterkörper in diesem Bereich eine $n^-$-Dotierung mit einer Konzentration von $10^{14}cm^{-3}$ besitzt. Im diffundierten Bereich besitzt der Halbleiterkörper 10'' eine maximale $n^+$-Dotierung von $10^{20}cm^{-3}$, die gemäß dem Diffusionsprofil nach innen zu abfällt.

Die polierte, undiffundierte Oberfläche des Halbleiterkörpers 10'' wird anschließend mit dem Halbleiterkörper 10', der eine homogene Dotierungskonzentration $p^+$ von $10^{20}cm^{-3}$ besitzt, nach dem Silicium-Verschmelzungs-Verbindungsverfahren verbunden. Anschließend werden auf die beiden freiliegenden Oberflächen des hierbei entstandenen Halbleiterelements dünne Metallschichten 11 aufgebracht, wobei sich die Art der Metallschichten nach der eingesetzten Montagetechnik richtet. Für Lötvorgänge ist z.B. die Schichtenfolge Al/Ni oder Cr/Ni/Ag geeignet.

Abschließend wird das Halbleiterelement 10 durch Sägen oder andere Trennverfahren ist einzelne Siliciumchips unterteilt.

Nach der Zerteilung werden die einzelnen Chips zwischen jeweils zwei Anschlüsse gelötet, die vorzugsweise aus Kupfer bestehen. Nach diesem Lötvorgang sind beide Chip-Stirnflächen durch das Lot und die Anschlüsse vollständig abgedeckt.

Der beim Zerteilungsschritt seitlich freigelegte und beschädigte pn-Übergang wird anschließend z.B. naßchemisch in heißer Kalilauge oder im Plasma geätzt, um die Beschädigungen abzutragen. Durch Entfernung einer seitlichen Siliciumschicht von ca. 30 bis 40 µm sind alle Beschädigungen beseitigt, so daß die Diode auch bei hohen Sperrspannungen (von z.B. 1000 V) nur kleine Leckströme erzeugt, die typisch bei 100 nA bei Raumtemperatur liegen.

Aufgrund der Abdeckung der Chip-Stirnflächen durch das Lot und die Anschlüsse sind diese während des Ätzvorganges gegen Abtragung geschützt. Abschließend kann die fertige Leistungsdiode z.B. mit Kunststoff umhüllt werden, so daß sie passiviert und gegenüber Umgebungseinflüssen geschützt ist.

Die erfindungsgemäß hergestellte Leistungsdiode zeichnet sich durch niedrige Flußspannung bei hohen Strömen aus, wozu auch der homogen, hoch mit Bor dotierte Halbleiterkörper 10' wesentlich beiträgt. Um dies zu verdeutlichen, sind in Figur 8 zwei Kurven 12 und 13 einander gegenübergestellt, wobei die Kurve 12 den Dotierungkonzentrationsverlauf bei herkömmlich hergestellten Leistungsdioden veranschaulicht, während die Kurve 13 den Dotierungskonzentrationsverlauf zeigt, der mit dem erfindungsgemäßen Verfahren erreichbar ist. Ersichtlich ist der Konzentrationsübergang zwischen dem $p^+$-Bereich und dem angrenzenden $n^-$-Bereich bei der Erfindung sehr abrupt. Hierbei lassen sich Halbleiterelemente erzielen, deren spezifischer Widerstand bei 1 mOhm.cm liegt. Demgegenüber führt das abfallende Konzentrationsprofil bei herkömmlichen Leistungsdioden, die durch Diffusion des $p^+$-Bereichs erzeugt wurden, zu höherem elektrischen Schichtwiderstand, wobei der Durchschnittswert des spezifischen Widerstandes selbst bei hoher Oberflächenkonzentration mindestens 50 mOhm.cm beträgt. Dies bewirkt, daß die Flußspannung bei den bekannten Ausführungsformen entsprechend höher ist. Dieser Nachteil bekannter Ausführungsformen tritt selbst dann auf, wenn die Breite der diffundierten p⁺-Schicht reduziert wird.

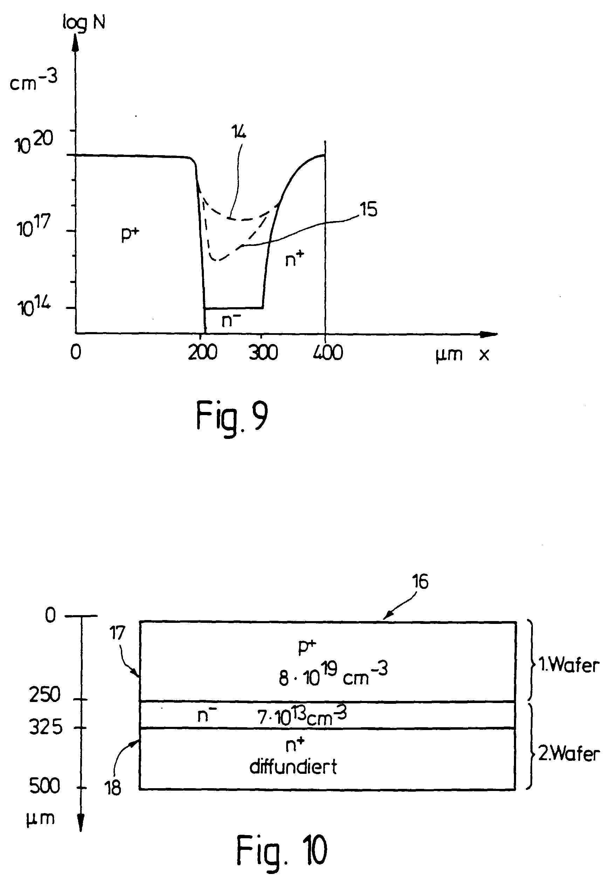

Die nach dem erfindungsgemäßen Verfahren hergestellte Diode ist weiterhin schnell- und weichschaltend. Um dies zu erreichen, muß die mit Ladungsträgern überschwemmte n⁻-Mittelzone rasch und ohne größere Stromsprünge ausgeräumt werden, wenn die Diode nach Belastung mit hohen Strömen in Flußrichtung wieder in den Sperrzustand geschaltet werden soll. Dieses rasche und weiche Umschalten wird durch die Ausbildung "hängender Injektionsprofile" deutlich begünstigt. In Figur 9 sind mit den Kurven 14 und 15 Injektionsprofile im Bereich der n⁻-Schicht dargestellt, wobei die Kurve 14 das Injektionsprofil bei herkömmlichen Ausführungsformen und die Kurve 15 das Injektionsprofil bei erfindungsgemäß hergestellten Leistungsdioden veranschaulicht. Wie aus Figur 9 ersichtlich ist, hängt das Injektionsprofil bei der Erfindung deutlich tiefer und abrupter durch als bei herkömmlichen Ausführungsformen, so daß sich aufgrund der verringerten Ladungsträgerkonzentration am pn-Übergang eine schnelle Ausbildung der Raumladungszone bei Übergang in den Sperrzustand erreichen läßt. Über die sich ins n⁻-Gebiet ausdehnende Raumladungszone fließt die restliche Speicherladung zu den Kontakten hin ab, wobei der Ausräumstrom nur langsam abflacht. Damit läßt sich ein rasches Freiräumen ohne abrupte Änderungen des Ausräumstroms sicherstellen.

Ferner ist es bei dem erfindungsgemäßen Verfahren möglich, die Ladungsträgerlebensdauer am pn-Übergang zusätzlich gezielt zu beeinflussen. Dies erreicht man dadurch, daß die einzelnen Halbleiterkörper so miteinander verbunden werden, daß sie sich in ihrer kristallographischen Orientierung unterscheiden. Dies führt dazu, daß in der Kontaktzone Fehlanpassungs(Misfit-)-Versetzungen auftreten. Eine vergleichbare Wirkung ergibt sich beim Bonden von Halbleiterkörpern unterschiedlicher Gitterkonstanten, die beispielsweise durch unterschiedliche Dotierung der gebondeten Halbleiterkörper bedingt sind.

Um den Einfluß der kristallographischen Fehlorientierung zu belegen, wurden mehrere Halbleiterelemente gefertigt, die den in Figur 10 schematisch dargestellten Grundaufbau besaßen. Jedes Halbleiterelement 16 bestand aus zwei Halbleiterkörpern 17, 18, von denen der Halbleiterkörper 17 homogen hoch mit Bor mit einer Konzentration von $8 \cdot 10^{19} cm^{-3}$ dotiert war. In die Rückseite des schwach n⁻-dotierten Halbleiterkörpers 18 war Phosphor bis zu einer Tiefe von 175 μm eindiffundiert worden, wonach dann die beiden Halbleiterkörper 17 und 18 so nach dem SFB-Verfahren miteinander verbunden wurden, daß die n⁻-Schicht des Halbleiterkörpers 18 dem Halbleiterkörper 17 zugewandt war. Die Gesamtdicke jedes Halbleiterkörpers vor dem Verbindungsschritt betrug 250 μm, so daß die Dicke des resultierenden Halbleiterelements 500 μm betrug.

Beide Halbleiterkörper 17, 18 hatten (111)-orientierte Oberflächen, wobei die (01$\bar{1}$)-Fläche jedes Halbleiterkörpers durch eine Markierung (Flat) gekennzeichnet war. Der Winkel α zwischen den Markierungen wurde bei den einzelnen Halbleiterelementen variiert.

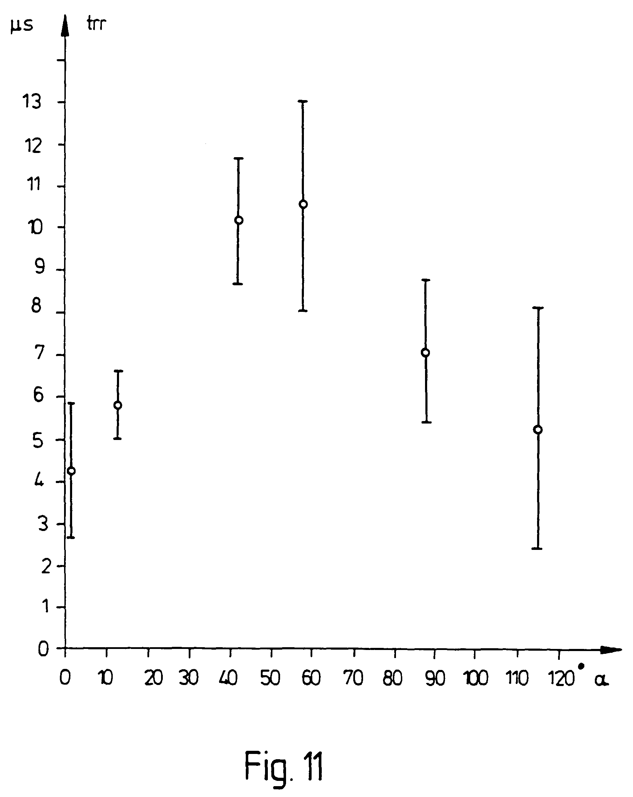

In Figur 11 sind experimentell erhaltene Werte für unterschiedliche Winkel α, d.h. für unterschiedliche kristallographische Orientierungswinkel der beiden Halbleiterkörper, dargestellt. Auf der Abszisse sind die Winkelwerte α aufgetragen, während auf der Ordinate die Rückwärtserholzeit trr in Mikrosekunden angegeben ist.

Aus Figur 11 ist ersichtlich, daß die jeweils gemessene Rückwärtserholzeit trr bei Winkeln α von 0° und 120° Minima besitzt, die ungefähr zwischen 4 und 5 Mikrosekunden liegen. Bei einem Versetzungswinkel α von 60° ergibt sich demgegenüber ein maximaler Wert von knapp 11 Mikrosekunden für die Rückwärtserholzeit. Da die Rückwärtserholzeit trr proportional zur Ladungsträgerlebensdauer ist, bedeutet dies, daß durch Steuerung des Winkels zwischen der kristallographischen Orientierung der beiden miteinander zu verbindenden Halbleiterkörper die Ladungsträgerlebensdauer gezielt beeinflußt werden kann, um gewünschte Diodencharakteristiken zu erzielen. Eine gleiche Wirkung läßt sich auch, wie ausgeführt, durch Zusammenbonden von Halbleiterkörpern unterschiedlicher Gitterkonstanten hervorrufen.

Diese erfindungsgemäßen Steuerungsmaßnahmen zur Beeinflussung der Diodencharakteristik bzw. der Ladungsträgerlebensdauer sind auch deshalb von Bedeutung, da dieser Eingriff ohne wesentliche Beeinflussung der übrigen Diodenparameter erfolgen kann. Die anderen Diodenparameter wie etwa der Sperrkennlinienverlauf oder die Flußspannung werden nämlich nicht oder nur geringfügig beeinflußt. Dies belegt die nachfolgend wiedergegebene Tabelle, in der für unterschiedliche Versetzungswinkel α die sich hierbei jeweils ergebenden Werte für die Sperrspannung $U_r(V)$ bei einem Sperrstrom von 10 μA sowie für die Flußspannung $U_f(V)$ bei einer Strombelastung von 100 A aufgelistet sind.

| α | 1,5° | 13° | 42° | 58° | 88° | 115° |
|---|---|---|---|---|---|---|
| $U_r(V)$, 10μA | 750 | 800 | 720 | 740 | 740 | 820 |
| | ±240 | ±140 | ±140 | ±130 | ±140 | ±120 |
| $U_f(V)$, 100 A | 1,30 | 1,26 | 1,26 | 1,25 | 1,36 | 1,37 |
| | ±0,05 | ±0,01 | ±0,02 | ±0,01 | ±0,07 | ±0,09 |

Die in der vorstehenden Tabelle angegebenen Werte beziehen sich auf eine Chipfläche von 14 mm$^2$. Die Verbindung der beiden Halbleiterkörper 17, 18 gemäß dem SFB-Verfahren erfolgte über zwei Stunden bei 1080° C unter Stickstoffatmosphäre. Eine weitere Beeinflussungsmöglichkeit für die Steuerung der Ladungsträgerlebensdauer am pn-Übergang, insbesondere eine noch weitere Verringerung der Ladungsträgerlebensdauer, kann dadurch erreicht werden, daß in die Kontaktzone zwischen den miteinander zu verbindenden Halbleiterkörpern Fremdatome eingebaut werden. In der am einfachsten zu realisierenden Variante bestehen die Fremdatome z.B. aus Sauerstoff, der in der dünnen natürlichen Oxidschicht auf den miteinander zu verbindenden Halbleiterkörper-Flächen vorhanden ist. Alternativ können die Fremdatome durch Schwermetalle wie etwa Gold oder Platin gebildet sein, die vor der Verbindung der Halbleiterkörper auf deren zu verbindenden Oberflächen aufgebracht werden.

Insbesondere ist von Bedeutung, daß die Rekombinationszentren durch die erfindungsgemäß mit dem pn-Übergang gekoppelte Versetzungszone und durch die niedrigen Temperaturen und kurzen Behandlungszeiten beim Bonden in der Nähe des pn-Übergangs angereichert werden und dabei das "hängende Injektionsprofil" erzeugen.

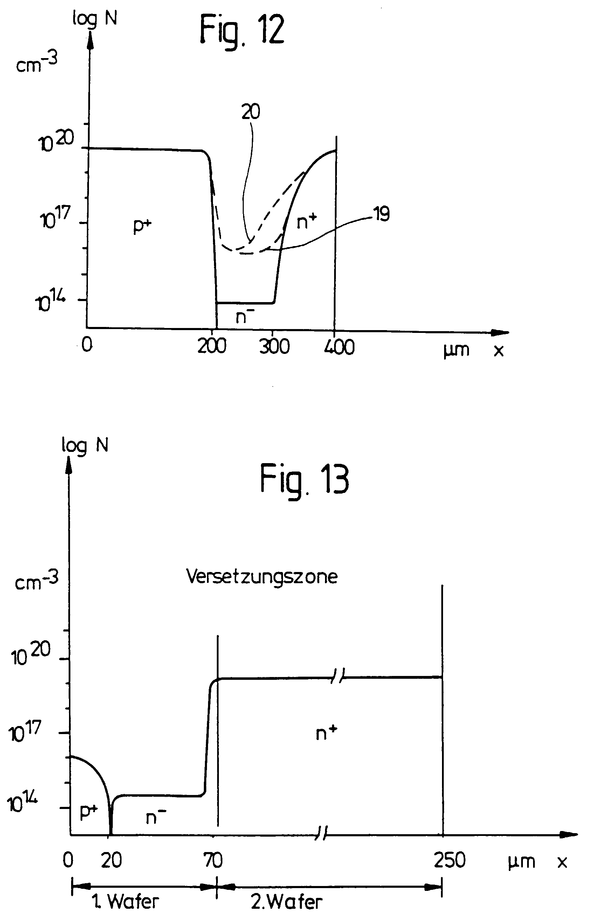

Die erfindungsgemäßen Verfahrensschritte bringen insbesondere bei hochsperrenden Bauelementen sehr gute Ergebnisse, da sie trotz der für hochsperrende Bauelemente erforderlichen breiten Mittelgebiete (für die Aufnahme der Raumladungszone) niedrige Flußspannung aufweisen und schnell- und weichschaltend sind. Wenn die gleichzeitige Erfüllung aller vorgenannten Eigenschaften angestrebt wird, verbietet sich nämlich eine homogene Aufdotierung des gesamten Halbleiterelements mit Schwermetallen wie etwa Gold oder Platin, da dies die Ladungsträgerlebensdauer über die gesamte Mittelzone verringern und folglich ein starkes Ansteigen der Flußspannung hervorrufen würde. Um dies zu veranschaulichen, ist in Figur 12 schematisch der Dotierungskonzentrationsverlauf eingetragen, wobei eine Kurve 20 den sich bei erfindungsgemäß hergestellten Halbleiterelementen einstellenden Verlauf im Mittelgebiet veranschaulicht, während eine Kurve 19 den Verlauf bei herkömmlicher Ausführung, unter homogener Aufdotierung mit Gold, erzielten Verlauf repräsentiert.

In Figur 13 ist der Dotierungskonzentrationsverlauf für eine nach dem erfindungsgemäßen Verfahren hergestellte Diode in Form einer asymmetrischen Diode, die auf einer der beiden Halbleiterelementseiten niedrige Oberflächenkonzentration besitzt, dargestellt. In Figur 13 ist auf der Abszisse die jeweilige Position entlang eines Längsschnitts durch das erfindungsgemäß hergestellte Halbleiterelement aufgetragen, während auf der Ordinate die jeweils zugehörigen Dotierungskonzentrationen angegeben sind. Wie aus Figur 13 ersichtlich ist, sind die beiden zusammengebondeten Halbleiterkörper im fertigen Halbleiterelement unterschiedlich stark, wobei der eine Halbleiterkörper homogene Dotierung hoher $n^+$-Konzentration besitzt und eine Dicke von ca. 180 μm aufweist, während der andere Halbleiterkörper lediglich eine Dicke von 70 μm besitzt und angrenzend an den einen Halbleiterkörper eine Schicht niedriger Dotierung desselben Leitungstyps wie der des einen Halbleiterkörpers sowie eine weitere, ca. 20 μm starke eindiffundierte Schicht des anderen Leitungstyps mit einer Konzentration von ungefähr $10^{16}$cm$^{-3}$ umfaßt.

Die Herstellung des in Figur 13 hinsichtlich seines Dotierungsprofils gezeigten Halbleiterelements erfolgt dadurch, daß zunächst ein hoch mit Phosphor dotiertes $n^+$-Substrat gegen ein schwach mit Phosphor dotiertes $n^-$-Substrat nach dem SFB-Verfahren gebondet wird. Danach wird die $n^-$-Schicht des Verbundkörpers soweit abgetragen, und zwar durch mechanische oder chemische Mittel, bis eine gewünschte verbleibende Dicke erreicht ist. Nachfolgend wird in die freiliegende Oberfläche des abgetragenen $n^-$-Substrats Bor mit niedriger Oberflächenkonzentration flach eindiffundiert, um die p-Zone auszubilden. Durch diese Diffusion werden die positiven elektrischen Eigenschaften des Halbleiterelements eingestellt. Aufgrund der hohen Dotierung der $n^+$-Schicht ist die Flußspannung, insbesondere wenn die Dotierung zusätzlich homogen ist, gegenüber diffundierten Schichten deutlich reduziert. Die Dotierung muß allerdings nicht in jedem Fall homogen sein.

Die Eindiffusion der $n^+$-Schicht erst nach der Verbindung der beiden Halbleiterkörper hat den weiteren Vorteil, daß die Versetzungszone zwischen dem $n^+$-Halbleiterkörper und dem $n^-$-Halbleiterkörper nicht wirksam werden kann, da sie während der Diffusion der Borschicht - aufgrund des sich hierbei ausdehnenden $n^+$-Bereichs - im $n^+$-Bereichs zu liegen kommt. Darüber hinaus wird ein Teil der Versetzungen auch durch die Getterwirkung während der Bordiffusion geheilt bzw. unschädlich.

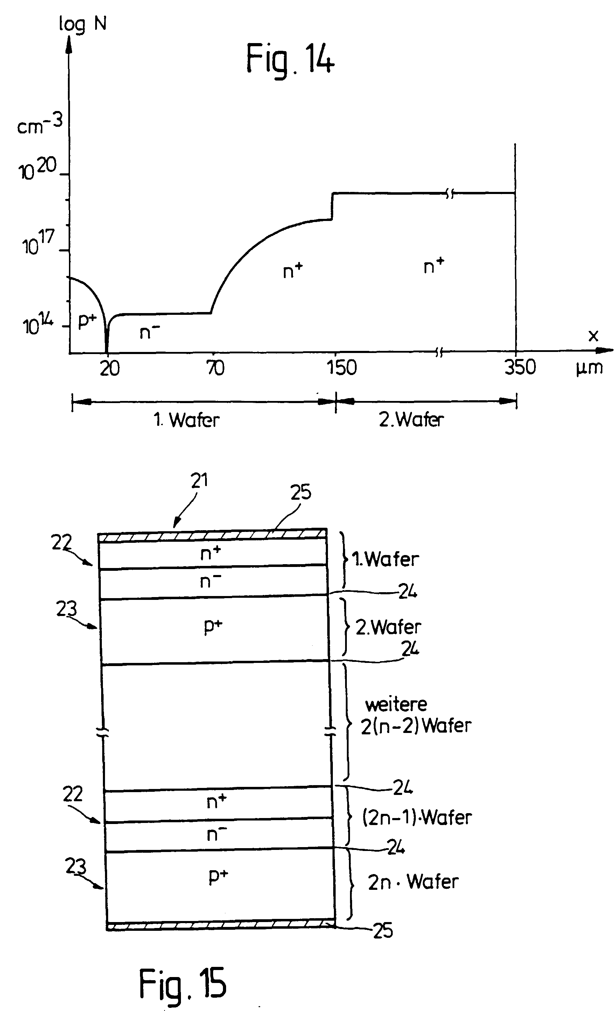

In Figur 14 ist der Dotierungskonzentrationsverlauf für ein weiteres Ausführungsbeispiel dargestellt, das nach einer Variante des erfindungsgemäßen Verfahrens herstellbar ist. Das in Figur 14 hinsichtlich seines Dotierungsprofils veranschaulichte Halbleiterelement besteht aus zwei Halbleiterkörpern, die nach dem Silicium-Verschmelzungs-Verbindungsverfahren miteinander verbunden wurden. Der eine Halbleiterkörper weist hohe, vorzugsweise homogene Dotierung ($n^+$) von ca. $10^{19}$cm$^{-3}$ auf, während der andere Halbleiterkörper drei Schichten unterschiedlicher Dotierungsdichte umfaßt. Die dem ersten Halbleiterkörper benachbarte Schicht enthält $n^+$-Dotierung, so daß an der Verbindungsstelle zwischen den beiden Halbleiterkörpern ein nur geringer Dotierungskonzentrationssprung auftritt. Die mittlere Schicht des zweiten Halbleiterkörpers ist $n^-$-dotiert, während die äußere Schicht des zweiten Halbleiterkörpers $n^+$ mit einer Oberflächenkonzentration von $10^{16}$cm$^{-3}$ dotiert ist. Die räumlichen Abmessungen der einzelnen Schichten sind aus Figur 14 ablesbar.

Das durch Figur 14 veranschaulichte Ausführungsbeispiel läßt sich dadurch herstellen, daß zunächst der eine Halbleiterkörper (Wafer 1) nacheinander mit Phosphor und Bor diffundiert wird, so daß der in Figur 14 diesbezüglich gezeigte Dotierungsverlauf resultiert. Anschließend wird ein starkes n$^+$-Substrat von beispielsweise 200 μm Dicke auf die n$^+$-Schicht des ersten Wafers gebondet, um die mechanische Stabilität zu steigern. Die Versetzungszone im Kontaktbereich der beiden Halbleiterkörper ist völlig unschädlich, da sie im hochdotierten Bereich liegt und folglich die Injektion nicht behindern kann.

Vorteilhaft ist es, die Bordiffusion und die Verbindung der beiden Halbleiterkörper simultan auszuführen, was zusätzliche Kosteneinsparung bringt und auch zeitlich rascher durchführbar ist.

Auch dieses Ausführungsbeispiel besitzt - gegenüber den eingangs genannten bekannten Ausführungsformen - die vorstehend aufgelisteten Vorteile.

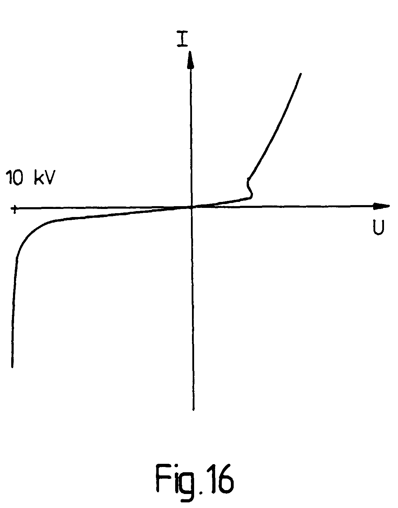

In Figur 15 ist ein Querschnitt durch ein Ausführungsbeispiel des Halbleiterelements in Form einer gestapelten Hochspannungsdiode 21 gezeigt, die sich gleichfalls nach dem erfindungsgemäßen Verfahren herstellen läßt.

Die Hochspannungsdiode 21 umfaßt mehrere Halbleiterkörper (Wafer) 22, 23, die abwechselnd aufeinander geschichtet sind. Der Halbleiterkörper 22 enthält zwei Schichten unterschiedlicher Dotierungskonzentration, und zwar eine n$^+$- und eine n$^-$-Schicht. Der Halbleiterkörper 23 besteht demgegenüber aus einer einzigen, hochdotierten p$^+$-Schicht, vorzugsweise mit homogener Dotierung. Die Halbleiterkörper 22 und 23 sind abwechselnd aufeinander gestapelt, so daß sich übereinander gestapelte n$^+$-n$^-$p$^+$-Strukturen ergeben. Die Verbindung der Halbleiterkörper 22, 23 erfolgt, vorzugsweise für alle Halbleiterkörper in einem Schritt, gemäß dem Silicium-Verschmelzungs-Verbindungsverfahren (SFB), wobei die zwischen den einzelnen Halbleiterkörpern resultierenden Kontaktzonen mit 24 bezeichnet sind.

Im einzelnen werden bei dem erfindungsgemäßen Verfahren zur Herstellung der gestapelten Hochspannungsdiode 21 zunächst mehrere mit Phosphor dotierte n$^-$-Substrate einseitig mit Phosphor diffundiert, wonach die Oxide abgeätzt werden und eine RCA-Reinigung durchgeführt wird. Anschließend werden alternierend diffundierte Halbleiterkörper und homogen, hoch mit Bor dotierte p$^+$-Halbleiterkörper übereinander gestapelt und durch Temperaturbehandlung bei 1080° C für zwei Stunden nach dem SFB-Verfahren gebondet. Die zu bondenden Flächen sind poliert.

Alternativ ist es auch möglich, n$^-$-Halbleiterkörper und p$^+$-Halbleiterkörper miteinander in Kontakt zu bringen, wobei in der Kontaktzone eine Phosphorbelegung (auf einer oder beiden der jeweils miteinander zu verbindenden Flächen) vorhanden ist. Die Phosphorbelegung kann durch Implantation oder andere Verfahren erfolgen. Bei dieser Variante kann die Diffusion dann gleichzeitig mit dem Bonden nach dem SFB-Verfahren erfolgen, so daß die Kosten und der Zeitaufwand weiter verringert sind.

Anschließend werden auf die freiliegenden Oberflächen des Waferverbunds Metallschichten 25 zur elektrischen Kontaktierung aufgetragen.

Das vorstehend beschriebene Verfahren zur Herstellung von Hochspannungsdioden hat die Vorteile, daß es nur geringen Aufwand erfordert, und daß keine Löt- und Legierungs-Schichten zwischen den einzelnen Halbleiterkörpern notwendig sind, so daß keine beim nachfolgenden Zerteilen und gegebenenfalls Ätzen der Halbleiterkörper störenden Metallschichten vorhanden sind. Auch interne Löt- und Legierungsvorgänge, die nur schwer beherrschbar sind, können vollständig entfallen.

In Figur 16 ist die Strom-Spannungs-Kennlinie der erfindungsgemäß hergestellten Hochspannungsdiode gezeigt. Ersichtlich hat die Hochspannungsdiode hohe Sperrspannungskapazität bis 10 kV. Die Durchbruchspannung des p$^+$-n$^+$-Übergangs zwischen den Halbleiterkörpern 22, 23 kann durch hohe Oberflächenkonzentration auf sehr niedrige Werte eingestellt werden, wobei der Tunneleffekt ausgenutzt wird. Damit ist die elektrische Charakteristik der erfindungsgemäß hergestellten Dioden insbesondere bei höheren Strömen nicht negativ beeinflußt.

**Patentansprüche**

1. Verfahren zur Herstellung von Halbleiterelementen, bei dem mindestens zwei Halbleiterkörper durch Verschmelzen miteinander verbunden werden und bei dem an der Verbindungsfläche einer der beiden Halbleiterkörper im Vergleich zum anderen Halbleiterkörper eine höhere Leitfähigkeit des einen Leitungstyps besitzt und im anderen Halbleiterkörper zumindest zwei Schichten unterschiedlicher Dotierungsdichte, von denen zumindest eine Schicht entgegengesetzten Leitungstyp wie der eine Halbleiterkörper besitzt, ausgebildet werden, dadurch gekennzeichnet, daß die Halbleiterkörper so miteinander verbunden werden, daß sie sich in ihrer kristallographischen Orientierung unterscheiden.

2. Verfahren nach Anspruch 1, dadurch gekennzeichnet, daß der andere Halbleiterkörper zwei Halbleiterschichten umfaßt, die beide denselben, zum Leitungstyp des einen Halbleiterkörgers entgegengesetzten Leitungstyp haben und unterschiedlich stark dotiert sind, und daß der eine Halbleiterkörper mit der schwächer dotierten Schicht des anderen halbleiterkörpers verbunden wird.

3. Verfahren nach Anspruch 2, dadurch gekennzeichnet, daß zur Ausbildung von Hochspannungsdioden mehrere Halbleiterkörper in Stapelbauweise aufeinander aufgebracht und gleichzeitig miteinander verbunden werden.

**4.** Verfahren nach einem oder mehreren der vorhergehenden Ansprüche, dadurch gekennzeichnet, daß Halbleiterkörper verwendet werden, die an den für ihre Verbindung vorgesehenen Oberflächen unterschiedliche Gitterkonstanten haben.

**5.** Verfahren nach einem oder mehreren der vorhergehenden Ansprüche, dadurch gekennzeichnet, daß in die Kontaktzone zwischen den miteinander verbundenen Halbleiterkörpern Fremdatome eingebaut werden.

**6.** Verfahren nach Anspruch 5, dadurch gekennzeichnet, daß als Fremdatome Sauerstoffatome oder - moleküle in Oxidschichten auf den miteinander verbundenen Halbleiterkörper-Oberflächen dienen.

**7.** Verfahren nach Anspruch 5 oder 6, dadurch gekennzeichnet, daß vor dem Verbinden der Halbleiterkörper-Oberflächen ein Schwermetall, insbesondere Gold oder Platin, auf die Oberflächen aufgebracht wird.

**8.** Verfahren nach einem oder mehreren der vorhergehenden Ansprüche, dadurch gekennzeichnet, daß der eine Halbleiterkörger homogen hoch dotiert ist.

**9.** Verfahren nach einem oder mehreren der vorhergehenden Ansprüche, dadurch gekennzeichnet, daß der andere Halbleiterkörper aus Halbleitermaterial schwächerer Dotierung mit demselben Leitungstyp wie der eine Halbleiterkörper besteht und die zumindest eine Schicht entgegengesetzten Leitungstyps entweder nach oder während dem Verschmelzen der beiden Halbleiterkörper ausgebildet wird.

**10.** Verfahren nach einem oder mehreren der vorhergehenden Ansprüche, dadurch gekennzeichnet, daß die Oberfläche eines der beiden Halbleiterkörper nach dem Verschmelzen der beiden Halbleiterkörper mechanisch oder chemisch abgetragen wird.

**11.** Verfahren nach einem oder mehreren der vorhergehenden Ansprüche, dadurch gekennzeichnet, daß der andere Halbleiterkörper $p^+n^-n^+$-Struktur besitzt.

**12.** Verfahren nach einem oder mehreren der vorhergehenden Ansprüche, dadurch gekennzeichnet, daß die freiliegenden Hauptflächen der miteinander verbundenen Halbleiterkörper mit Metall beschichtet werden, die Halbleiterkörper danach in einzelne Chips zerteilt werden, die Chips mit einer Lotschicht und Anschlüssen versehen werden und anschließend die Seitenkanten der Chips abgeätzt werden.

**13.** Verfahren nach einem oder mehreren der vorhergehenden Ansprüche, dadurch gekennzeichnet, daß der Verbindungsschritt zur Verbindung der Halbleiterkörper bei Temperaturen über 1000°C für mehr als eine Stunde unter Stickstoffatmosphäre durchgeführt wird.

**14.** Verfahren nach einem oder mehreren der vorhergehenden Ansprüche, dadurch gekennzeichnet, daß der Verbindungsschritt zur Verbindung der Halbleiterkörper bei 1080°C für zwei Stunden unter Stickstoffatmosphäre, durchgeführt wird.

## Claims

**1.** Method of manufacturing semiconductor elements, in which at least two semiconductor bodies are bonded to one another by fusion, and in which, at the bonding area, one of the two semiconductor bodies has a higher conductivity of the one conduction type in comparison with the other semiconductor body, and at least two layers having a different doping density, of which at least one layer has the opposite conduction type to the one semiconductor body, are formed in the other semiconductor body, characterized in that the semiconductor bodies are bonded to one another in such a way that they differ in terms of their crystallographic orientation.

**2.** Method according to Claim 1, characterized in that the other semiconductor body comprises two semiconductor layers which both have the same conduction type, opposite to the conduction type of the one semiconductor body, and have different degrees of doping, and in that the one semiconductor body is connected to the more weakly doped layer of the other semiconductor body.

**3.** Method according to Claim 2, characterized in that, in order to form high-voltage diodes, a plurality of semiconductor bodies are applied to one another in a stack design and are simultaneously bonded to one another.

4. Method according to one or more of the preceding claims, characterized in that use is made of semiconductor bodies which have different lattice constants at the surfaces provided for their bonding.

5. Method according to one or more of the preceding claims, characterized in that impurity atoms are incorporated in the contact zone between the semiconductor bodies bonded to one another.

6. Method according to Claim 5, characterized in that the impurity atoms used are oxygen atoms or molecules in oxide layers on the semiconductor body surfaces bonded to one another.

7. Method according to Claim 5 or 6, characterized in that the bonding of the semiconductor body surfaces is preceded by the application of a heavy metal, in particular gold or platinum, to the surfaces.

8. Method according to one or more of the preceding claims, characterized in that the one semiconductor body is homogeneously highly doped.

9. Method according to one or more of the preceding claims, characterized in that the other semiconductor body is composed of semiconductor material of weaker doping with the same conduction type as the one semiconductor body, and the at least one layer of the opposite conduction type is formed either after or during the fusion of the two semiconductor bodies.

10. Method according to one or more of the preceding claims, characterized in that the surface of one of the two semiconductor bodies is mechanically or chemically removed after the fusion of the two semiconductor bodies.

11. Method according to one or more of the preceding claims, characterized in that the other semiconductor body has a $p^+n^-n^+$ structure.

12. Method according to one or more of the preceding claims, characterized in that the exposed main areas of the semiconductor bodies bonded to one another are coated with metal, the semiconductor bodies are then divided into individual chips, the chips are provided with a solder layer and connections and the side edges of the chips are subsequently etched away.

13. Method according to one or more of the preceding claims, characterized in that the bonding step for bonding the semiconductor bodies is carried out at temperatures above 1000°C for more than 1 hour under a nitrogen atmosphere.

14. Method according to one or more of the preceding claims, characterized in that the bonding step for bonding the semiconductor bodies is carried out at 1080°C for two hours under a nitrogen atmosphere.


**Revendications**

1. Procédé de fabrication d'éléments semi-conducteurs, selon lequel on réunit au moins deux semi-conducteurs par fusion et, au niveau de la surface de liaison de l'un des deux semi-conducteurs, par comparaison avec l'autre semi-conducteur, on a une conductivité plus élevée d'un type de conduction et, dans l'autre semi-conducteur, on a au moins deux couches à densités de dopage différentes, dont au moins une couche est de conductivité de type opposé à celui du semi-conducteur,
caractérisé en ce que
les semi-conducteurs sont réunis pour que leurs orientations cristallographiques soient différentes.

2. Procédé selon la revendication 1,
caractérisé en ce que
l'autre semi-conducteur comprend deux couches semi-conductrices qui ont toutes deux le même type de conduction, opposé au type de conduction de l'autre semi-conducteur, et leur dopage a une épaisseur différente, l'un des semi-conducteurs étant relié à la couche de dopage plus faible de l'autre semi-conducteur.

3. Procédé selon la revendication 2,
caractérisé en ce que
pour réaliser les diodes à haute tension, on superpose plusieurs semi-conducteurs en les empilant et on les relie en même temps.

4. Procédé selon l'une ou plusieurs des revendications précédentes,
caractérisé en ce qu'
on utilise des semi-conducteurs ayant des constantes de réseaux différentes pour les surfaces destinées à être reliées.

5. Procédé selon l'une ou plusieurs des revendications précédentes,
caractérisé en ce qu'
on introduit des atomes étrangers dans la zone de contact entre les semi-conducteurs à relier.

6. Procédé selon la revendication 5,
caractérisé en ce que
comme atomes étrangers, on utilise des atomes d'oxygène ou des molécules dans les couches d'oxyde sur les surfaces des semi-conducteurs reliés.

7. Procédé selon la revendication 5 ou 6,
caractérisé en ce qu'
avant de relier les surfaces des semi-conducteurs, on applique un métal lourd, notamment de l'or ou de platine, sur les surfaces.

8. Procédé selon l'une ou plusieurs des revendications précédentes,
caractérisé en ce que
l'un des semi-conducteurs homogène est fortement dopé.

9. Procédé selon l'une ou plusieurs des revendications précédentes,
caractérisé en ce que
l'autre semi-conducteur est en une matière semi-conductrice à plus faible dopage de même type de conduction que l'autre semi-conducteur, et au moins l'une des couches est de conductivité de type opposé, réalisée soit après soit pendant la fusion des deux semi-conducteurs.

10. Procédé selon l'une ou plusieurs des revendications précédentes,
caractérisé en ce que
la surface de l'un des deux semi-conducteurs est enlevée par un moyen mécanique ou chimique après la fusion des deux semi-conducteurs.

11. Procédé selon l'une ou plusieurs des revendications précédentes,
caractérisé en ce que
l'autre semi-conducteur a une structure $p^+n^-n^+$.

12. Procédé selon l'une ou plusieurs des revendications précédentes,
caractérisé en ce que
les surfaces principales libres des semi-conducteurs, reliés, sont revêtues avec du métal, puis les semi-conducteurs sont subdivisés en puces et les puces reçoivent une couche de brasure et des bornes, les arêtes latérales de chaque puce étant attaquées par voie chimique.

13. Procédé selon l'une ou plusieurs des revendications précédentes,
caractérisé en ce que
l'étape de liaison pour relier les semi-conducteurs est effectuée à des températures supérieures à 1 000°C pendant plus d'une heure sous une atmosphère d'azote.

14. Procédé selon l'une ou plusieurs des revendications précédentes,
caractérisé en ce que
l'étape de liaison des semi-conducteurs est effectuée sous une atmosphère d'azote et à une température de 1 080°C.

Fig. 1

Fig. 2

Fig. 3

Fig. 4

Fig. 5

Fig. 6

# Fig. 7

# Fig. 8

log N

cm$^{-3}$

$10^{20}$

14

$10^{17}$

15

p$^+$

n$^+$

$10^{14}$

n$^-$

0          200          300          400          µm   x

Fig. 9

16

0

17

p$^+$
$8 \cdot 10^{19}$ cm$^{-3}$          1.Wafer

250

n$^-$          $7 \cdot 10^{13}$ cm$^{-3}$

325

n$^+$
diffundiert          2.Wafer

500

18

µm

Fig. 10

Fig. 11

Fig. 12

Fig. 13

## Fig. 14

## Fig. 15

10 kV

Fig.16